# EUROPEAN PATENT SPECIFICATION

(11) **EP 2 630 675 B1**
(45) Date of publication and mention of the grant of the patent: **11.09.2019**
(21) Application number: 11781577.9
(22) Date of filing: 18.10.2011
(51) Int. Cl.: H01L 51/54

(54) **ORGANIC LIGHT-EMITTING DEVICE AND METHOD**
ORGANISCHES LICHTEMITTIERENDES BAUELEMENT UND VERFAHREN
DISPOSITIF ÉLECTROLUMINESCENT ORGANIQUE ET PROCÉDÉ ASSOCIÉ

(30) Priority: 14.01.2011 GB 201100630; 19.10.2010 GB 201017626; 19.10.2010 GB 201017628
(43) Date of publication of application: 28.08.2013
(73) Proprietor: Cambridge Display Technology Limited, Cardinal Way Godmanchester Cambridgeshire PE29 2XG (GB); Sumitomo Chemical Company Limited, Tokyo 104-8260 (JP)
(72) Inventor: STEUDEL, Annette, Cambourne Business Park Cambridgeshire CB23 6DW (GB); FERNANDEZ, Oscar, Cambourne Business Park Cambridgeshire CB23 6DW (GB)
(74) Representative: Gilani, Anwar
(86) International application number: PCT/GB2011/001499
(87) International publication number: WO 2012/052713

(56) References cited:
- EP-A1- 1 245 659
- GB-A- 2 433 509
- GB-A- 2 456 788
- US-A- 5 998 045
- US-A1- 2007 057 630
- US-A1- 2008 026 250

## Description

### Summary of the Invention

This invention relates to organic light devices and methods of making the same.

### Background of the Invention

Electronic devices comprising active organic materials are attracting increasing attention for use in devices such as organic light emitting diodes, organic photovoltaic devices, organic photosensors, organic transistors and memory array devices. Devices comprising organic materials offer benefits such as low weight, low power consumption and flexibility. Moreover, use of soluble organic materials allows use of solution processing in device manufacture, for example inkjet printing or spin-coating.

A typical organic light-emissive device ("OLED") is fabricated on a glass or plastic substrate coated with a transparent anode such as indium-tin-oxide ("ITO"). A layer of a thin film of at least one electroluminescent organic material is provided over the first electrode. Finally, a cathode is provided over the layer of electroluminescent organic material. Charge transporting, charge injecting or charge blocking layers may be provided between the anode and the electroluminescent layer and / or between the cathode and the electroluminescent layer.

In operation, holes are injected into the device through the anode and electrons are injected into the device through the cathode. The holes and electrons combine in the organic electroluminescent layer to form an excitons which then undergo radiative decay to give light.

In WO90/13148 the organic light- emissive material is a conjugated polymer such as poly(phenylenevinylene). In US 4,539,507 the organic light-emissive material is of the class known as small molecule materials, such as tris-(8-hydroxyquinoline) aluminium ("Alq₃" ). These materials electroluminesce by radiative decay of singlet excitons (fluorescence) however spin statistics dictate that up to 75% of excitons are triplet excitons which undergo non-radiative decay, i. e. quantum efficiency may be as low as 25% for fluorescent OLEDs-see, for example, Chem. Phys. Lett., 1993,210, 61, Nature (London), 2001,409, 494, Synth. Met., 2002,125, 55 and references therein.

It has been postulated that the presence of excitons that do not undergo radiative decay can be detrimental to OLED lifetime. In particular triplet excitons, which may have relatively long-lived triplet excited states, may participate in undesirable triplet-triplet or triplet-singlet interactions ("lifetime" as used herein in the context of OLED lifetime means the length of time taken for the luminance of the OLED at constant current to fall by 50% from an initial luminance value, and "lifetime" as used herein in the context of lifetime of an exciton means the half-life of an exciton).

US 2007/145886 discloses an OLED comprising a triplet-quenching material to prevent or reduce triplet-triplet or triplet-singlet interactions.

US 2008/026250 discloses OLEDs containing iridium compounds comprising at least one cyclometallated ligand and at least one ketopyrrole ligand.

OLEDs have great potential for display and lighting applications. However, there remains a need to improve performance of these devices.

### Summary of the Invention

In a first aspect, the invention provides an organic light-emitting device according to claim 1.

Optionally, the charge transporting layer is a hole transporting layer located between the anode and the electroluminescent layer.

Optionally, the light-emitting layer comprises a polymer.

Optionally, the polymer is a light-emitting polymer.

Optionally, the light-emitting layer comprises a host material and a light-emitting dopant that is mixed with or chemically bound to the host material.

Optionally, the polymer is the host material.

Optionally, the charge-transporting polymer or the polymer comprised in the light-emitting layer comprises arylamine repeat units.

Optionally, the arylamine repeat units are units of formula (V): 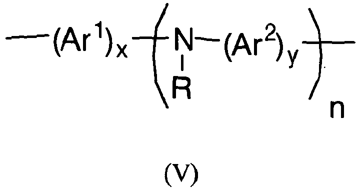 wherein Ar¹ and Ar² are optionally substituted aryl or heteroaryl groups, n is greater than or equal to 1, preferably 1 or 2, x and y are each independently at least 1, and R is H or a substituent.

Optionally, the polymer comprises aryl or heteroaryl repeat units.

Optionally, the polymer comprises repeat units of formula (IV): 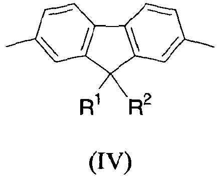 wherein R¹ and R² are independently H or a substituent, and R¹ and R² may be linked to form a ring.

Optionally, the polymer comprises phenylene repeat units, optionally 1,4-phenylene repeat units, substituted with one or more substituents. Optionally, the polymer ocmprises repeat units of formula (VII): 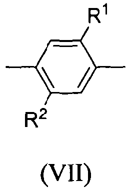 wherein R¹ and R² are independently H or a substituent.

In another aspect the invention provides a method of forming an organic light-emitting device according to the first aspect comprising the steps of depositing the charge transporting layer and the light-emitting layer over one of the anode and cathode and depositing the other of the anode and cathode over the charge transporting layer and the light-emitting layer.

According to the said aspect, at least one of the charge transporting layer and the light emitting layer are deposited from a solution in a solvent.

Optionally according to the aspect above, the first of the charge transporting layer and the light emitting layer to be deposited is crosslinked following deposition, and the other of the charge transporting layer and the light emitting layer is deposited onto the first-deposited layer from a solution in a solvent.

### Brief Description of the Drawings

Figure 1 illustrates an organic light-emitting device; and
Figure 2 illustrates a mechanism of light-emission in an OLED.

### Detailed Description of the Invention

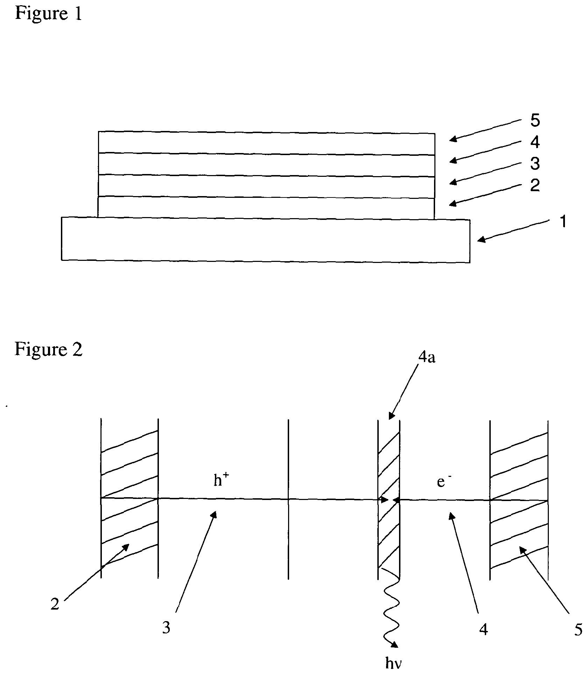

Figure 1 illustrates the structure of an OLED according to an embodiment of the invention. The OLED comprises a transparent glass or plastic substrate 1, an anode 2, a cathode 5, and a hole transporting layer 3 and a light-emitting layer 4 provided between anode 2 and the cathode 5. Further layers may be located between anode 2 and the cathode, such as charge transporting, charge injecting or charge blocking layers. For example, an electron transporting layer may be provided between light-emitting layer 4 and cathode 5.

With reference to Figure 2, holes are injected from the anode 2 and electrons are injected from cathode 5. The holes and electrons undergo recombination in a recombination zone 4a of the light emitting layer 4 to form excitons that undergo radiative decay.

However, not all of the excitons that are formed by recombination of holes and electrons undergo radiative decay, and these excitons may be detrimental to device lifetime. In particular, singlet or triplet excitons may migrate from light emitting layer 4 into hole transport layer 3. Moreover, excitons may be formed from electrons that pass through the light-emitting layer 4 and reach the hole transport layer. These excitons may interact with the material or materials of hole transport layer 3. The present inventors have identified that this interaction may reduce operational lifetime and/or efficiency of the device.

Exciton migration from the light-emitting layer may occur if recombination zone 4a is close to the interface between the hole transport layer 3. Moreover, triplet excitons are typically relatively long-lived species and as such may migrate into hole transport layer 3 even if the recombination zone 4a is relatively distant from the interface between hole transport layer 3 and light emitting layer 4.

Figure 2 illustrates an OLED having a hole transport layer into which excitons may migrate from the light emitting layer. If an electron transporting layer is present between the light emitting layer and cathode of an OLED (in which a hole transport layer may or may not be present) then it will be appreciated that excitons could equally migrate into the electron transporting layer with the similar detrimental effects. Likewise, holes reaching the electron transport layer could recombine with electrons to form excitons in the electron transporting layer.

By incorporation of a light-emitting dopant into the hole transport layer 2 (and / or electron transporting layer, if present), the present inventors have found that device lifetime may be improved. Without wishing to be bound by any theory, it is believed that the improvement in lifetime is attributable to absorption of excitons in the hole transport layer by the light-emitting dopant, which then allows the exciton to release its energy in the form of light.

A number of measures may be taken to minimise the effect of the colour of light emitted from the charge transport layer on the colour of light emitted from the device, as compared to a control device in which no light-emitting dopant is present in the charge-transporting layer. These measures include but are not limited to:
(i) Providing only a small quantity of dopant in the charge-transporting layer in order to minimise the amount of light emitted by that dopant. The inventors have surprisingly found that a dramatic increase in lifetime is achievable even at very low (no more than 0.75 mol %) doping levels.
(ii) When the light-emitting layer and the charge transporting layer are in contact, for example as shown in Figures 1 and 2, locating the recombination zone of the light-emitting layer at a distance from the interface of the charge transport layer and the light-emitting layer in order to reduce the number of excitons reaching the charge transporting layer. This may be done using techniques known to the skilled person. For example, the thickness of the charge transporting layer may be reduced and / or the thickness of the light-emitting layer may be increased.
(iii) Using a dopant in the charge transporting layer that emits light having the same or substantially the same colour as light emitted from the light emitting layer. This may entail, for example, using the same dopant in both the light-emitting layer and the charge transporting layer, or different dopants that emit the same or substantially the same colour of light.

Each of these measures may be used alone or in combination.

### Charge-transporting layer

The charge-transporting layer comprises a charge-transporting polymer and a light-emitting dopant according to the claims. The charge-transporting polymer has an excited state energy level that is higher than an excited state energy level of the light-emitting dopant. The triplet excited state energy level (T₁) of the charge transporting polymer should be higher than that of the phosphorescent light-emitting dopant in order that triplet excitons may be transferred from the charge transporting polymer to the phosphorescent light-emitting dopant. The triplet level of the charge transporting polymer should be at least 0.01 eV higher than the triplet level of the phosphorescent dopant, more preferred 0.05 eV higher, even more preferred 0.1 eV or higher. The charge transporting polymer may be a conjugated or non-conjugated polymer, and charge transporting units may be provided in a polymer main-chain or polymer side-chain.

A hole transporting layer preferably comprises a material having a low electron affinity (2 eV or lower) and low ionisation potential (5.8 eV or lower, preferably 5.7 eV or lower, more preferred 5.6 eV or lower). Electron affinities and ionisation potentials are typically measured by the methods disclosed in Shirota and Kageyama, Chem. Rev. 2007, 107, 953-1010 and references therein.

A hole-transporting polymer may comprise arylamine repeat units, in particular repeat units of formula (V): 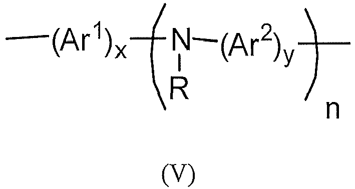 wherein Ar¹ and Ar² in each occurrence are independently selected from optionally substituted aryl or heteroaryl groups, n is greater than or equal to 1, preferably 1 or 2, R is H or a substituent, preferably a substituent, and x and y are each independently 1, 2 or 3.

R is preferably alkyl, Ar³, or a branched or linear chain of Ar³ groups, for example -(Ar³)ᵣ, wherein Ar³ in each occurrence is independently selected from aryl or heteroaryl and r is at least 1, optionally 1, 2 or 3.

Any of Ar¹, Ar² and Ar³ may independently be substituted with one or more substituents. Preferred substituents are selected from the group R³ consisting of:
alkyl wherein one or more non-adjacent C atoms may be replaced with O, S, substituted N, C=O and -COO- and one or more H atoms of the alkyl group may be replaced with F or aryl or heteroaryl optionally substituted with one or more groups R⁴,
aryl or heteroaryl optionally substituted with one or more groups R⁴,
NR⁵₂, OR⁵, SR⁵,
fluorine, nitro and cyano;
wherein each R⁴ is independently alkyl in which one or more non-adjacent C atoms may be replaced with O, S, substituted N, C=O and -COO- and one or more H atoms of the alkyl group may be replaced with F, and each R⁵ is independently selected from the group consisting of alkyl and aryl or heteroaryl optionally substituted with one or more alkyl groups.

R may comprise a crosslinkable-group, for example a group comprising a polymerisable double bond such and a vinyl or acrylate group, or a benzocyclobutane group.

Any of the aryl or heteroaryl groups in the repeat unit of Formula (V) may be linked by a direct bond or a divalent linking atom or group. Preferred divalent linking atoms and groups include O, S; substituted N; and substituted C.

Where present, substituted N or substituted C of R³, R⁴ or of the divalent linking group may independently in each occurrence be NR⁶ or CR⁶₂ respectively wherein R⁶ is alkyl or optionally substituted aryl or heteroaryl. Optional substituents for aryl or heteroaryl groups R⁶ may be selected from R⁴ or R⁵.

In one preferred arrangement, R is Ar³ and each of Ar¹, Ar² and Ar³ are independently and optionally substituted with one or more C₁₋₂₀ alkyl groups.

Particularly preferred units satisfying Formula 1 include units of Formulae 1-3: 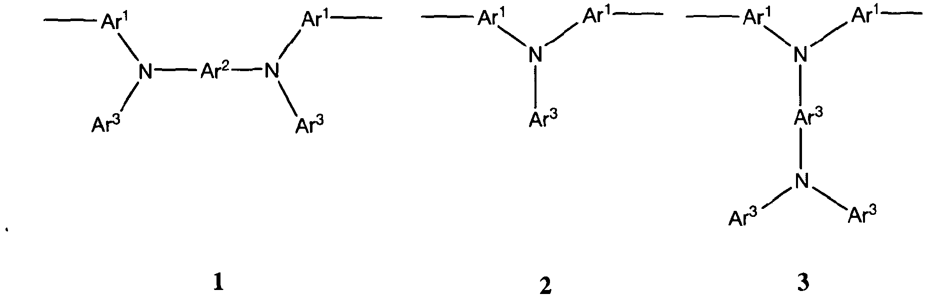 wherein Ar¹ and Ar² are as defined above; and Ar³ is optionally substituted aryl or heteroaryl. Where present, preferred substituents for Ar³ include substituents as described for Ar¹ and Ar², in particular alkyl and alkoxy groups.

Ar¹, Ar² and Ar³ are preferably phenyl, each of which may independently be substituted with one or more substituents as described above.

In another preferred arrangement, aryl or heteroaryl groups of formula (V) are phenyl, each phenyl group being optionally substituted with one or more alkyl groups.

In another preferred arrangement, Ar¹, Ar² and Ar³ are phenyl, each of which may be substituted with one or more C₁₋₂₀ alkyl groups, and r = 1.

In another preferred arrangement, Ar¹ and Ar² are phenyl, each of which may be substituted with one or more C₁₋₂₀ alkyl groups, and R is 3,5-diphenylbenzene wherein each phenyl may be substituted with one or more alkyl groups.

In yet another preferred arrangement, Ar¹, Ar² and Ar³ are phenyl, each of which may be substituted with one or more C₁₋₂₀ alkyl groups, r = 1 and Ar¹ and Ar² are linked by an O or S atom.

In one embodiment, Ar¹, Ar² and Ar³ are each phenyl and are each optionally substituted with one or more alkyl groups, in particular C₁₋₂₀ alkyl.

Specific hole transporting units include the following: 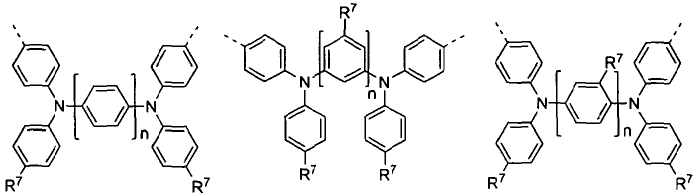 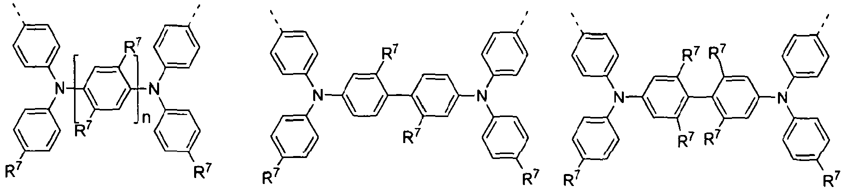 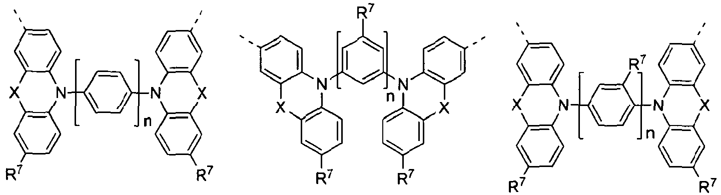 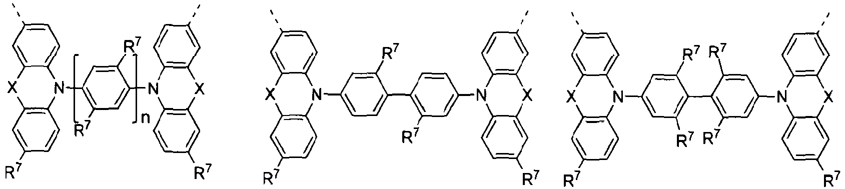 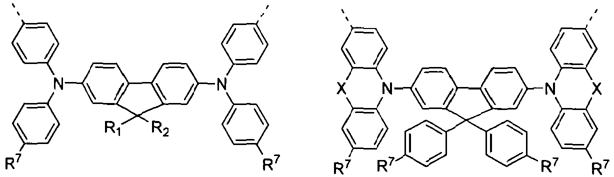 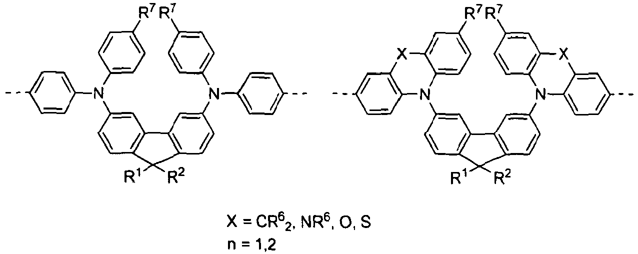 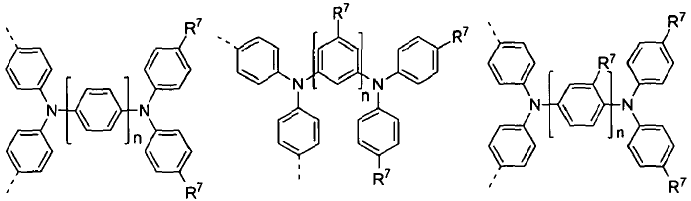 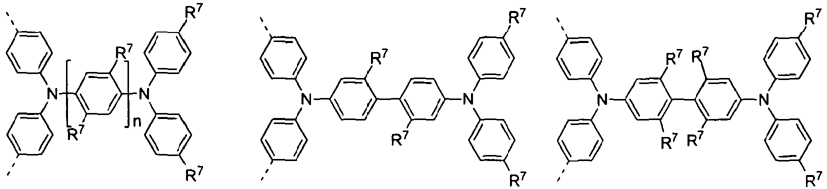 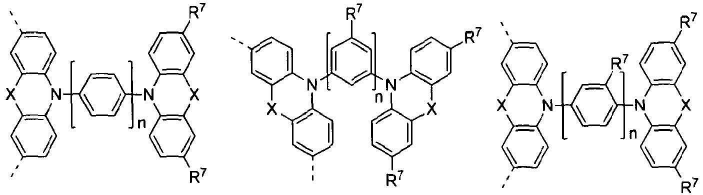 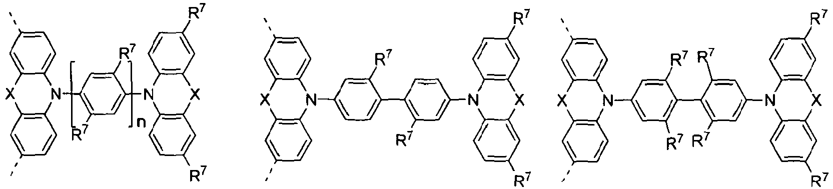 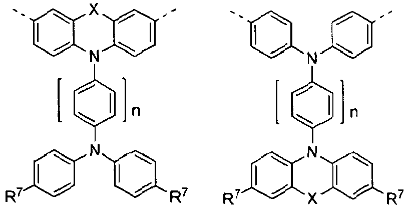 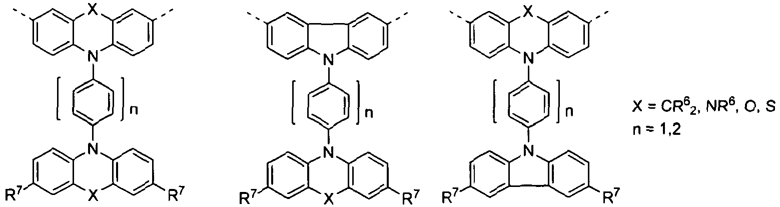 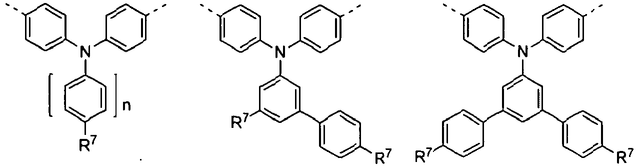 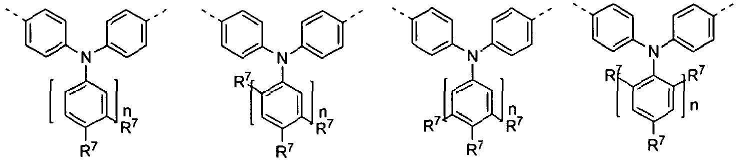 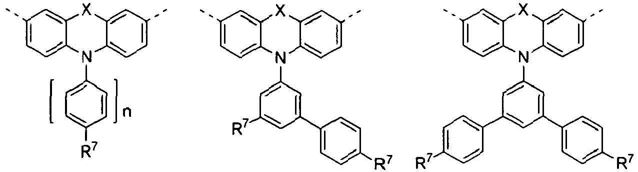 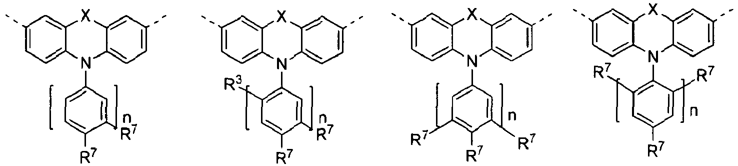 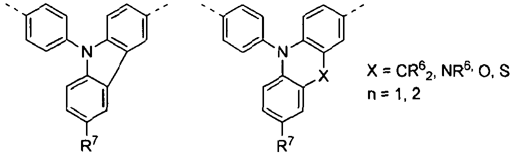 wherein R⁷ in each occurrence is independently H or a substituent, for example H or R³.

Exemplary bipolar groups include the following: 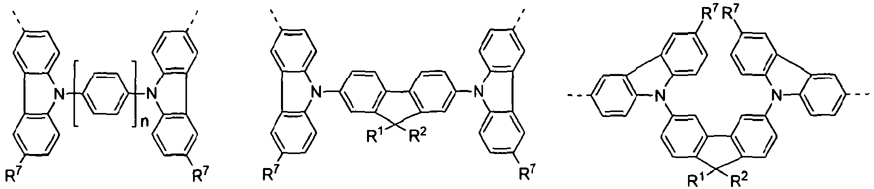 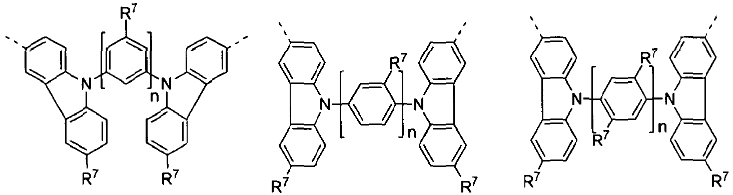 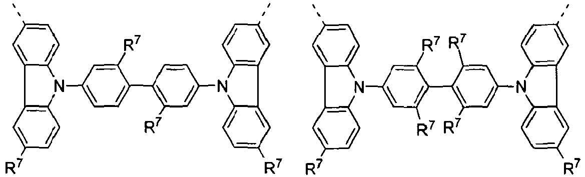 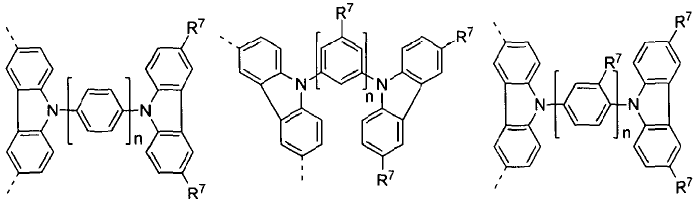 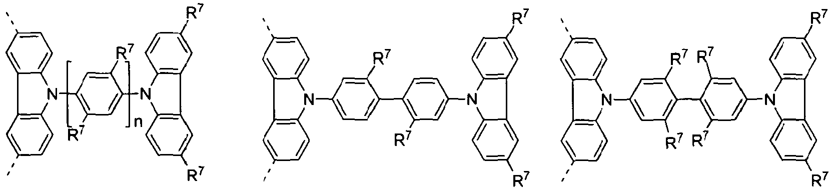 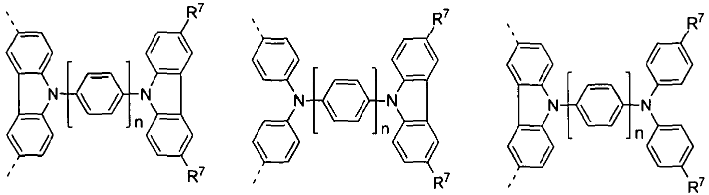 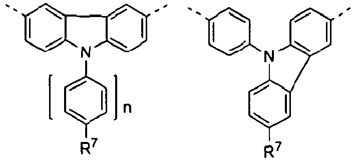 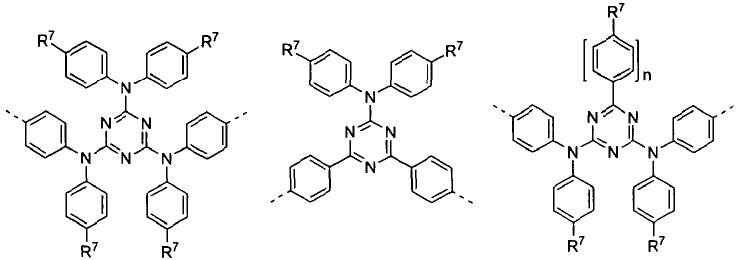 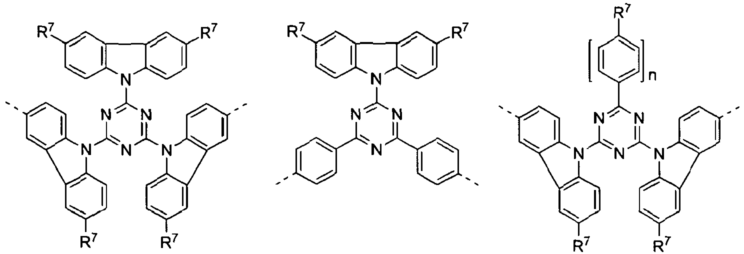 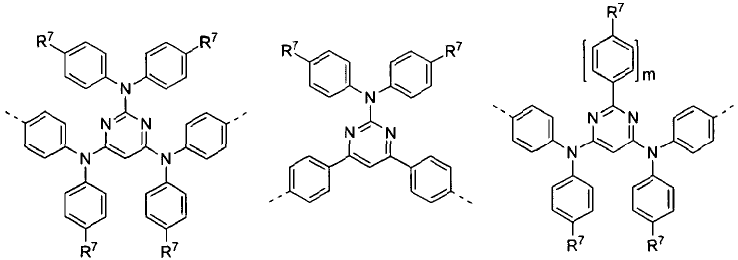 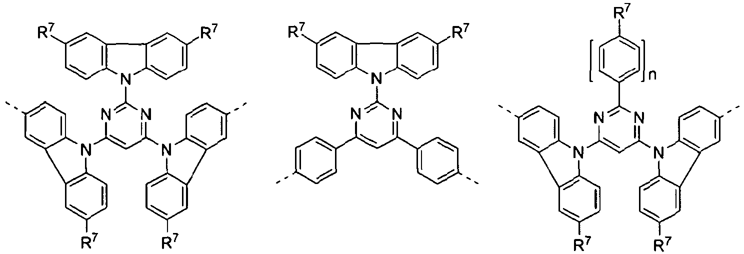 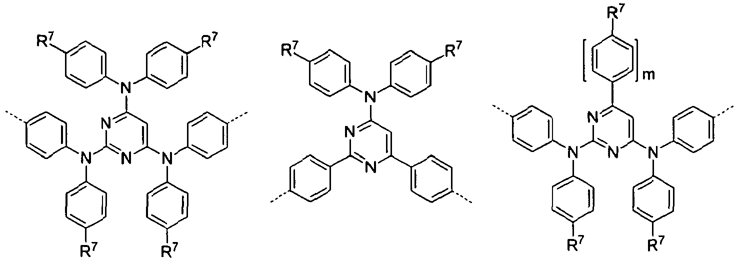 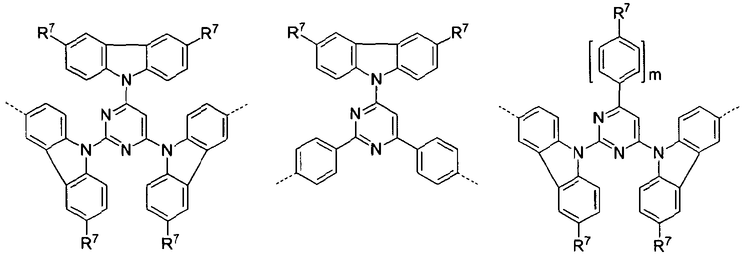 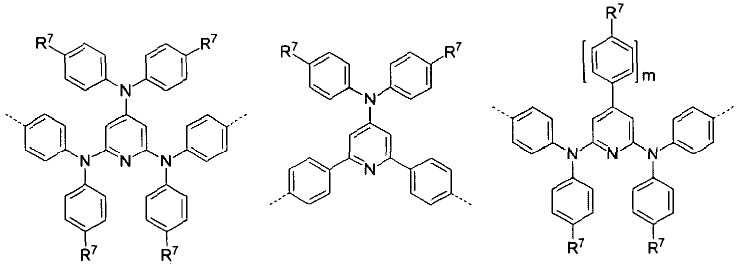 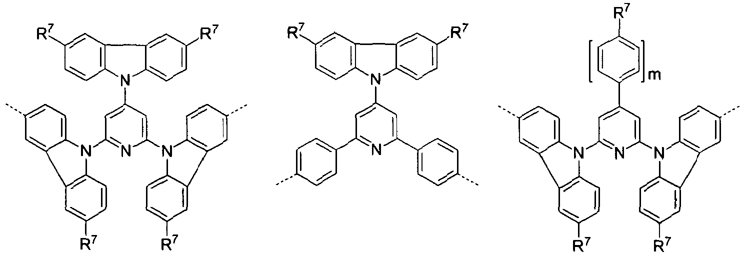 wherein R⁷ is as described above.

This polymer may be a homopolymer or it may be a copolymer comprising repeat units of formula (V) in an amount up to 99 mol %, preferably up to 70 mol %, even more preferred up to 50 mol%. These percentages apply to the total number of arylamine units present in the polymer in the case where more than one type of repeat unit of formula (V) is used.

In the case where the hole-transporting polymer is a co-polymer, suitable co-polymers include co-polymers comprising a repeat unit of formula (V) and an arylene or heteroarylene co-repeat unit. Exemplary arylene repeat units are disclosed in for example, Adv. Mater. 2000 12(23) 1737-1750 and include: 1,4-phenylene repeat units as disclosed in J. Appl. Phys. 1996, 79, 934; fluorene repeat units as disclosed in EP 0842208; indenofluorene repeat units as disclosed in, for example, Macromolecules 2000, 33(6), 2016-2020; and spirofluorene repeat units as disclosed in, for example EP 0707020. Each of these repeat units is optionally substituted. Examples of substituents include solubilising groups such as C₁₋₂₀ alkyl or alkoxy; electron withdrawing groups such as fluorine, nitro or cyano; and substituents for increasing glass transition temperature (Tg) of the polymer.

Particularly preferred arylene repeat units comprise optionally substituted, 2,7-linked fluorenes, most preferably repeat units of formula IV: 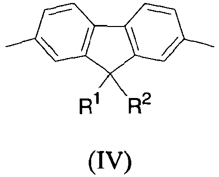 wherein R¹ and R² are independently H or a substituent and wherein R¹ and R² may be linked to form a ring. R¹ and R² are preferably selected from the group consisting of hydrogen; optionally substituted alkyl wherein one or more non-adjacent C atoms may be replaced with O, S, N, C=O and -COO-; optionally substituted aryl or heteroaryl, in particular aryl or heteroaryl substituted with one or more alkyl groups, e.g. C₁₋₂₀ alkyl; and optionally substituted arylalkyl or heteroarylalkyl. More preferably, at least one of R¹ and R² comprises an optionally substituted alky, e.g. C₁-C₂₀ alkyl, or aryl, in particular phenyl, group. R¹ and R² may each independently comprise a linear or branched chain of aryl or heteroaryl groups, each of which groups may independently be substituted, for example a group of formula (Ar³)ᵣ as described above.

In the case where R¹ or R² comprises aryl or heteroaryl, preferred optional substituents include alkyl groups wherein one or more non-adjacent C atoms may be replaced with O, S, N, C=O and -COO-.

R¹ and / or R² may comprise a crosslinkable-group, for example a group comprising a polymerisable double bond such and a vinyl or acrylate group, or a benzocyclobutane group. Optional substituents for the fluorene unit, other than substituents R¹ and R², are preferably selected from the group consisting of alkyl wherein one or more non-adjacent C atoms may be replaced with O, S, N, C=O and -COO-, optionally substituted aryl, optionally substituted heteroaryl, alkoxy, alkylthio, fluorine, cyano and arylalkyl.

"Aryl(ene)" and "heteroaryl(ene)" as used herein includes both fused and unfused aryl and heteroaryl groups respectively.

If light emission occurs from one or more phosphorescent emitters, a preferred arylene repeat unit is optionally substituted phenylene repeat units, such as 1,4-phenylene. The phenylene repeat unit may be substituted with one or more groups R¹ as described above, wherein each R¹ is independently in each occurrence H or a substituent, for example alkyl, for example repeat units of the formula (VII): 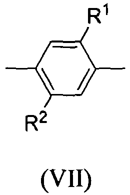 wherein R¹ and R² are the same or different and are as described above with reference to the repeat unit of formula (IV).

Preferred methods for preparation of conjugated charge-transporting polymers comprise a "metal insertion" wherein the metal atom of a metal complex catalyst is inserted between an aryl or heteroaryl group and a leaving group of a monomer. Exemplary metal insertion methods are Suzuki polymerisation as described in, for example, WO 00/53656 and Yamamoto polymerisation as described in, for example, T. Yamamoto, "Electrically Conducting And Thermally Stable π - Conjugated Poly(arylene)s Prepared by Organometallic Processes", Progress in Polymer Science 1993, 17, 1153-1205. In the case of Yamamoto polymerisation, a nickel complex catalyst is used; in the case of Suzuki polymerisation, a palladium complex catalyst is used.

For example, in the synthesis of a linear polymer by Yamamoto polymerisation, a monomer having two reactive halogen groups is used. Similarly, according to the method of Suzuki polymerisation, at least one reactive group is a boron derivative group such as a boronic acid or boronic ester and the other reactive group is a halogen. Preferred halogens are chlorine, bromine and iodine, most preferably bromine.

It will therefore be appreciated that repeat units illustrated throughout this application may be derived from a monomer carrying suitable leaving groups. Likewise, an end group or side group may be bound to the polymer by reaction of a suitable leaving group.

Suzuki polymerisation may be used to prepare regioregular, block and random copolymers. In particular, homopolymers or random copolymers may be prepared when one reactive group is a halogen and the other reactive group is a boron derivative group. Alternatively, block or regioregular, in particular AB, copolymers may be prepared when both reactive groups of a first monomer are boron and both reactive groups of a second monomer are halogen.

As alternatives to halides, other leaving groups capable of participating in metal insertion include groups include tosylate, mesylate and triflate.

An electron transporting layer preferably comprises a material having a high electron affinity (1.8 eV or higher, preferably 2 eV or higher, even more preferred 2.2 eV or higher) and high ionisation potential (5.8 eV or higher) Suitable electron transport groups include groups disclosed in, for example, Shirota and Kageyama, Chem. Rev. 2007, 107, 953-1010.

Electron transporting repeat units include groups comprise formula (II):

-(Ar¹)ᵣ-Het-(Ar²)ᵣ- (II)

wherein Ar¹ and Ar² are as defined above; r is at least 1, preferably 1-3, and Het represents an optionally substituted heteroaryl group with high electron affinity . Optional substituents for Het are as described with respect to R above. In the case where Het is substituted with an aryl or heteroaryl group, this may be a group -(Ar³)r as described above.

Suitable heteroaryls with high electron affinity include triazine, pyrimidine, oxadiazole, pyridine, triazole, triarylborane, sulfoxide and silole, in particular triphenyltriazine substituted with one or more substituent groups, for example triphenyl triazine substituted with one or more C₁₋₂₀ alkyl groups.

Exemplary electron-transporting groups include the following: 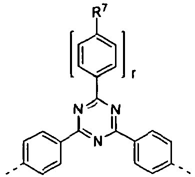 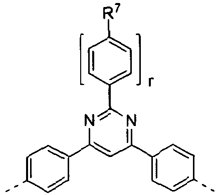 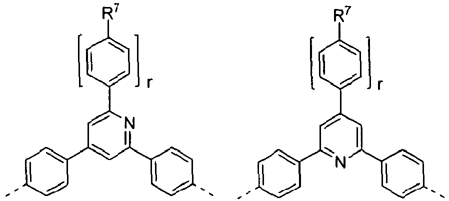 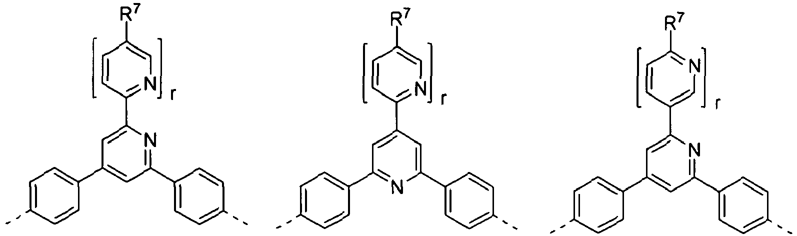 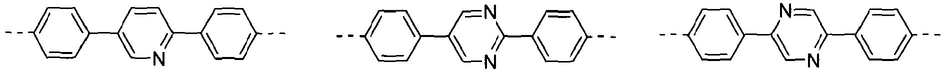 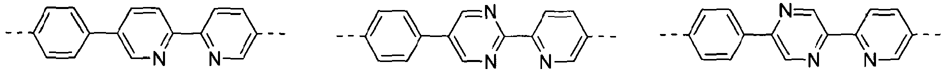 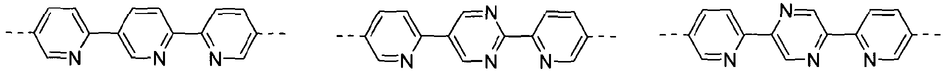 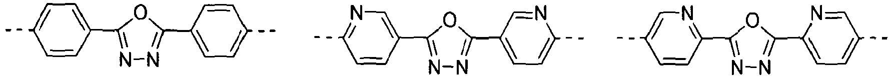 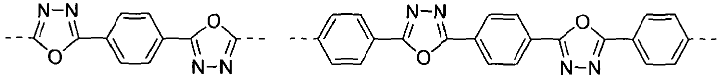 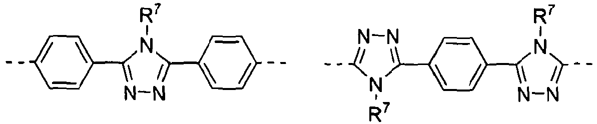 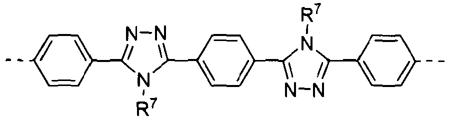 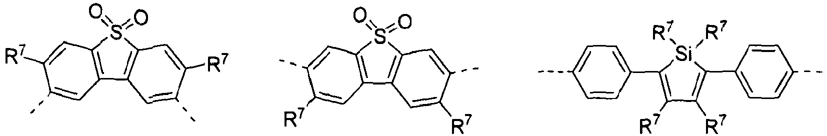 wherein R⁷ is as described above.

Other suitable electron transport materials include optionally substituted ketones, diarylsulfoxides, and phosphine oxides. 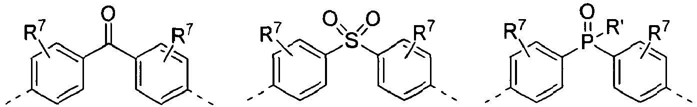 wherein R⁷ is as described above.

Other suitable electron transport materials include optionally substituted boranes, for example 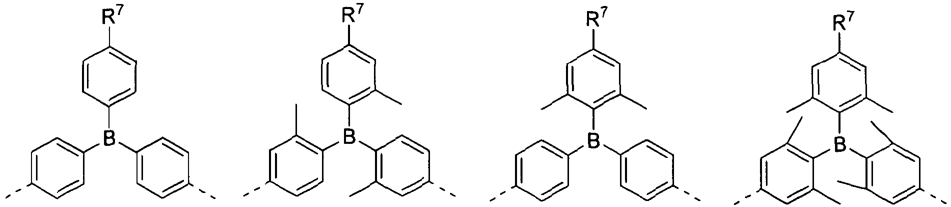 Wherein R⁷ is as described above.

Certain groups may function as both hole- and electron-transporting groups. These are so-called ambipolar groups and include carbazoles, in particular groups of formulae 1, 2 or 3 in which two of Ar¹, Ar² and Ar³ are phenyl groups linked by a direct C-C bond. Ambipolar groups typically have an electron affinity around 2 eV and ionisation potential around 5.8 eV. Depending on its electron affinity and ionisation potential, the charge transporting layer may both transport one of holes and electrons and block the other of holes and electrons.

Materials that may be used as phosphorescent light-emitting dopants according to the claims in the charge-transporting layer include metal complexes comprising optionally substituted complexes of formula (III):

ML¹_{q}L²ᵣL³ₛ (III)

wherein M is a metal; each of L¹ L² and L³ is a coordinating group; q is an integer; r and s are each independently 0 or an integer; and the sum of (a. q) + (b. r) + (c.s) is equal to the number of coordination sites available on M, wherein a is the number of coordination sites on L¹, b is the number of coordination sites on L² and c is the number of coordination sites on T³

Heavy elements M induce strong spin-orbit coupling to allow rapid intersystem crossing and emission from triplet or higher states (phosphorescence). Suitable heavy metals M include:
- lanthanide metals such as cerium, samarium, europium, terbium, dysprosium, thulium, erbium and neodymium; and
- d-block metals, in particular those in rows 2 and 3 i.e. elements 39 to 48 and 72 to 80, in particular ruthenium, rhodium, palladium, rhenium, osmium, iridium, platinum and gold. Iridium is particularly preferred.

Suitable coordinating groups for the f-block metals include oxygen or nitrogen donor systems such as carboxylic acids, 1,3-diketonates, hydroxy carboxylic acids,
Schiff bases including acyl phenols and iminoacyl groups. As is known, luminescent lanthanide metal complexes require sensitizing group(s) which have the triplet excited energy level higher than the first excited state of the metal ion. Emission is from an f-f transition of the metal and so the emission colour is determined by the choice of the metal. The sharp emission is generally narrow, resulting in a pure colour emission useful for display applications.

The d-block metals are particularly suitable for emission from triplet excited states. These metals form organometallic complexes with carbon or nitrogen donors such as porphyrin or bidentate ligands of formula (IV): 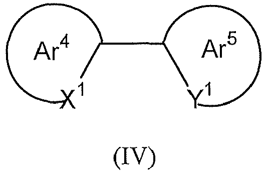 wherein Ar⁴ and Ar⁵ may be the same or different and are independently selected from optionally substituted aryl or heteroaryl; X¹ and Y¹ may be the same or different and are independently selected from carbon or nitrogen; and Ar⁴ and Ar⁵ may be fused together. Ligands wherein X¹ is carbon and Y¹ is nitrogen are particularly preferred.

Examples of bidentate ligands are illustrated below:

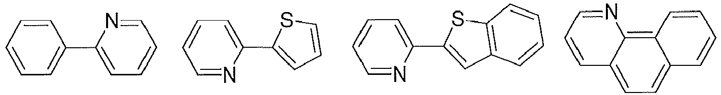

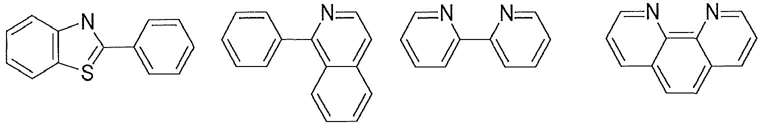

Each of Ar⁴ and Ar⁵ may carry one or more substituents. Two or more of these substituents may be linked to form a ring, for example an aromatic ring. Particularly preferred substituents include fluorine or trifluoromethyl which may be used to blue-shift the emission of the complex as disclosed in WO 02/45466, WO 02/44189, US 2002-117662 and US 2002-182441; alkyl or alkoxy groups as disclosed in JP 2002-324679; carbazole which may be used to assist hole transport to the complex when used as an emissive material as disclosed in WO 02/81448; bromine, chlorine or iodine which can serve to functionalise the ligand for attachment of further groups as disclosed in WO 02/68435 and EP 1245659; and dendrons which may be used to obtain or enhance solution processability of the metal complex as disclosed in WO 02/66552.

A light-emitting dendrimer typically comprises a light-emitting core bound to one or more dendrons, wherein each dendron comprises a branching point and two or more dendritic branches. Preferably, the dendron is at least partially conjugated, and at least one of the core and dendritic branches comprises an aryl or heteroaryl group.

Other ligands suitable for use with d-block elements include diketonates, in particular acetylacetonate (acac); triarylphosphines and pyridine, each of which may be substituted. Main group metal complexes show ligand based, or charge transfer emission. For these complexes, the emission colour is determined by the choice of ligand as well as the metal. The charge transporting layer may contain one or more light-emitting dopants.

The light-emitting dopant is chemically bound as a substituent attached to the polymer backbone of the charge transporting polymer, incorporated as a repeat unit in the polymer backbone or provided as an end-group of the polymer as disclosed in, for example, EP 1245659, WO 02/31896, WO 03/18653 and WO 03/22908.

This binding may result in more efficient transfer of excitons from the charge transporting materials to the light emitting dopant because it may provide intramolecular exciton transfer pathways unavailable to a corresponding mixed system.

Moreover, binding may be beneficial for processing reasons. For example, if the light emitting dopant has low solubility then binding it to a soluble charge transporting polymer allows the light emitting dopant to be carried in solution by the charge transporting polymer, enabling device fabrication using solution processing techniques. Furthermore, binding the light emitting dopant to the charge transporting polymer may prevent phase separation effects in solution-processed devices that may be detrimental to device performance.

The charge transporting layer is optionally at least 10 nm thick, optionally at least 15 nm thick, optionally at least 20 nm thick.

### Light emitting layer

Suitable light-emitting materials for use in the light-emitting layer include small molecule, polymeric and dendrimeric materials, and compositions thereof. Suitable light-emitting polymers for use in layer 3 include poly(arylene vinylenes) such as poly(p-phenylene vinylenes) and polyarylenes such as: polyfluorenes, particularly 2,7-linked 9,9 dialkyl polyfluorenes or 2,7-linked 9,9 diaryl polyfluorenes; polyspirofluorenes, particularly 2,7-linked poly-9,9-spirofluorene; polyindenofluorenes, particularly 2,7-linked polyindenofluorenes; polyphenylenes, particularly alkyl or alkoxy substituted poly-1,4-phenylene. Such polymers as disclosed in, for example, Adv. Mater. 2000 12(23) 1737-1750 and references therein.

Polymers for use as light-emitting materials in devices according to the present invention preferably comprise a repeat unit selected from optionally substituted arylene repeat units as described above, in particular phenylene repeat units such as repeat units of formula (VII) described above, and / or fluorene repeat units of formula (IV) described above.

A light-emitting polymer, in particular a fluorescent blue light-emitting polymer, may comprise an arylene or heteroarylene repeat unit as described above and an arylamine repeat unit, in particular a repeat unit of formula (V) as described above.

The light-emitting layer may consist of a light-emitting material alone, or may comprise this material in combination with one or more further materials. In particular, the light-emitting polymer may be blended with hole and / or electron transporting materials or alternatively may be covalently bound to hole and / or electron transporting materials as disclosed in for example, WO 99/48160. Exemplary hole and / or electron transporting materials may be selected from materials described above in relation to the charge-transporting layer.

Light-emitting copolymers may comprise a light-emitting region and at least one of a hole transporting region and an electron transporting region as disclosed in, for example, WO 00/55927 and US 6353083. If only one of a hole transporting region and electron transporting region is provided then the electroluminescent region may also provide the other of hole transport and electron transport functionality - for example, an amine unit as described above may provide both hole transport and light-emission functionality. A light-emitting copolymer comprising light-emitting repeat units and one or both of a hole transporting repeat units and electron transporting repeat units may provide said units in a polymer main-chain, as per US 6353083, or in polymer side-groups pendant from the polymer backbone.

The light emitting layer may comprise a host material and at least one light-emitting dopant. The host material may be a material as described above that would, in the absence of a dopant, emit light itself. When a host material and dopant are used in a device, the dopant alone may emit light. Alternatively, the host material and one or more dopants may emit light. White light may be generated by emission from multiple light sources, such as emission from both the host and one or more dopants or emission from multiple dopants. The light-emitting dopant may be selected from dopants as described above with respect to dopants present in the charge transporting layer.

In the case of a fluorescent light-emitting dopant the singlet excited state energy level (S₁) of the host material should be higher than that of the fluorescent light-emitting dopant in order that singlet excitons may be transferred from the host material to the fluorescent light-emitting dopant. The singlet level of the host material should be at least 0.01 eV higher than the singlet level of the light-emitting dopant, more preferred 0.05 eV higher, even more preferred 0.1 eV or higher. Likewise, in the case of a phosphorescent light-emitting dopant the triplet excited state energy level (T₁) of the host material should be higher than that of the phosphorescent light-emitting dopant in order that triplet excitons may be transferred from the host material to the fluorescent light-emitting dopant. The triplet level of the host material should be at least 0.01 eV higher than the triplet level of the phosphorescent light-emitting dopant, more preferred 0.05 eV higher, even more preferred 0.1 eV or higher.

The light-emitting dopant may be physically mixed with the host material or it may be chemically bound to the host material in the same manner described above with respect to binding of the light-emitting dopant to the charge transporting material.

The light-emitting layer may be patterned or unpatterned. A device comprising an unpatterned layer may be used an illumination source, for example. A white light emitting device is particularly suitable for this purpose. A device comprising a patterned layer may be, for example, an active matrix display or a passive matrix display. In the case of an active matrix display, a patterned electroluminescent layer is typically used in combination with a patterned anode layer and an unpatterned cathode. In the case of a passive matrix display, the anode layer is formed of parallel stripes of anode material, and parallel stripes of electroluminescent material and cathode material arranged perpendicular to the anode material wherein the stripes of electroluminescent material and cathode material are typically separated by stripes of insulating material ("cathode separators") formed by photolithography.

### Hole injection layers

A conductive hole injection layer, which may be formed from a conductive organic or inorganic material, may be provided between the anode and the light-emitting layer to assist hole injection from the anode into the layer or layers of semiconducting polymer. Examples of doped organic hole injection materials include optionally substituted, doped poly(ethylene dioxythiophene) (PEDT), in particular PEDT doped with a charge-balancing polyacid such as polystyrene sulfonate (PSS) as disclosed in EP 0901176 and EP 0947123, polyacrylic acid or a fluorinated sulfonic acid, for example Nafion®; polyaniline as disclosed in US 5723873 and US 5798170; and optionally substituted polythiophene or poly(thienothiophene). Examples of conductive inorganic materials include transition metal oxides such as VOx MoOx and RuOx as disclosed in Journal of Physics D: Applied Physics (1996), 29(11), 2750-2753.

### Cathode

The cathode is selected from materials that have a workfunction allowing injection of electrons into the electroluminescent layer. Other factors influence the selection of the cathode such as the possibility of adverse interactions between the cathode and the light-emitting material of the light-emitting layer, in particular if the cathode and light-emitting layer are in direct contact. The cathode may consist of a single material such as a layer of aluminium. Alternatively, it may comprise a plurality of metals, for example a bilayer of a low workfunction material and a high workfunction material such as calcium and aluminium as disclosed in WO 98/10621; elemental barium as disclosed in WO 98/57381, Appl. Phys. Lett. 2002, 81(4), 634 and WO 02/84759; or a thin layer of metal compound, in particular an oxide or fluoride of an alkali or alkali earth metal, to assist electron injection, for example lithium fluoride as disclosed in WO 00/48258; barium fluoride as disclosed in Appl. Phys. Lett. 2001, 79(5), 2001; and barium oxide. In order to provide efficient injection of electrons into the device, the cathode preferably has a workfunction of less than 3.5 eV, more preferably less than 3.2 eV, most preferably less than 3 eV. Work functions of metals can be found in, for example, Michaelson, J. Appl. Phys. 48(11), 4729, 1977.

The cathode may be opaque or transparent. Transparent cathodes are particularly advantageous for active matrix devices because emission through a transparent anode in such devices is at least partially blocked by drive circuitry located underneath the emissive pixels. A transparent cathode will comprises a layer of an electron injecting material that is sufficiently thin to be transparent. Typically, the lateral conductivity of this layer will be low as a result of its thinness. In this case, the layer of electron injecting material is used in combination with a thicker layer of transparent conducting material such as indium tin oxide.

It will be appreciated that a transparent cathode device need not have a transparent anode (unless, of course, a fully transparent device is desired), and so the transparent anode used for bottom-emitting devices may be replaced or supplemented with a layer of reflective material such as a layer of aluminium. Examples of transparent cathode devices are disclosed in, for example, GB 2348316.

### Encapsulation

OLEDs devices tend to be sensitive to moisture and oxygen. Accordingly, the substrate preferably has good barrier properties for prevention of ingress of moisture and oxygen into the device. The substrate is commonly glass, however alternative substrates may be used, in particular where flexibility of the device is desirable. For example, the substrate may comprise a plastic as in US 6268695 which discloses a substrate of alternating plastic and barrier layers or a laminate of thin glass and plastic as disclosed in EP 0949850.

The device is preferably encapsulated with an encapsulant (not shown) to prevent ingress of moisture and oxygen. Suitable encapsulants include a sheet of glass, films having suitable barrier properties such as silicon dioxide, silicon monoxide, silicon nitride or alternating stacks of polymer and dielectric as disclosed in, for example, WO 01/81649 or an airtight container as disclosed in, for example, WO 01/19142. In the case of a transparent cathode device, a transparent encapsulating layer such as silicon monoxide or silicon dioxide may be deposited to micron levels of thickness, although in one preferred embodiment the thickness of such a layer is in the range of 20-300 nm. A getter material for absorption of any atmospheric moisture and / or oxygen that may permeate through the substrate or encapsulant may be disposed between the substrate and the encapsulant.

### Solution processing

The charge-transporting layer may be deposited from a solution in a solvent, and the light-emitting layer may be deposited by any process, including vacuum evaporation and deposition from a solution in a solvent. In the case where one or both of these layers comprises a polyarylene, such as a polyfluorene, suitable solvents for solution deposition include mono- or poly-alkylbenzenes such as toluene and xylene. Particularly preferred solution deposition techniques including printing and coating techniques, preferably spin-coating and inkjet printing.

Spin-coating is particularly suitable for devices wherein patterning of the light-emitting material is unnecessary - for example for lighting applications or simple monochrome segmented displays.

Inkjet printing is particularly suitable for high information content displays, in particular full colour displays. A device may be inkjet printed by providing a patterned layer over the first electrode and defining wells for printing of one colour (in the case of a monochrome device) or multiple colours (in the case of a multicolour, in particular full colour device). The patterned layer is typically a layer of photoresist that is patterned to define wells as described in, for example, EP 0880303.

As an alternative to wells, the ink may be printed into channels defined within a patterned layer. In particular, the photoresist may be patterned to form channels which, unlike wells, extend over a plurality of pixels and which may be closed or open at the channel ends.

Other solution deposition techniques include dip-coating, roll printing and screen printing.

If adjacent charge transport layer and light-emitting layer are formed by solution processing then the skilled person will be aware of techniques to prevent intermixing of these layers, for example by crosslinking of one layer before deposition of the subsequent layer or selection of materials for adjacent layers such that the material from which the first of these layers is formed is not soluble in the solvent used to deposit the second layer.

### Examples

Hole transporting polymer was formed from the following monomers by Suzuki polymerisation as described in WO 00/53656:

| Monomer | Comparative hole transport polymer 1 (Mol %) | Hole transport polymer 1 (Mol%) | Hole transport polymer 2 (Mol%) | Hole transport polymer 3 (Mol %) |
|---|---|---|---|---|
| 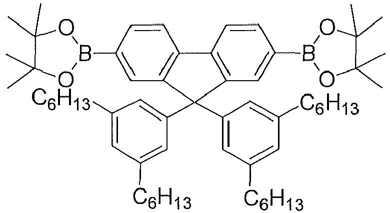 | 50 | 50 | 50 | 50 |
| 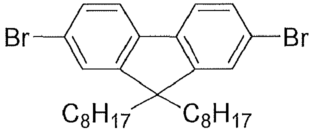 | 12.5 | 10.5 | 12.25 | 11.5 |
| 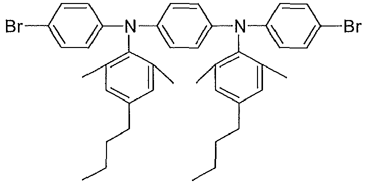 | 30 | 30 | 30 | 30 |
| 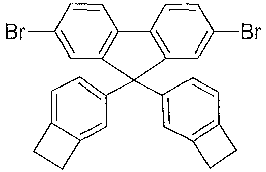 | 7.5 | 7.5 | 7.5 | |
| 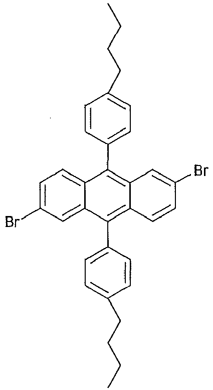 | | 2 | | |
| 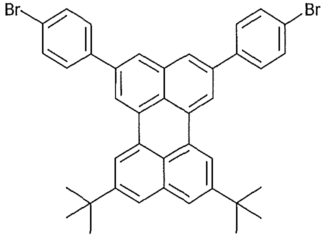 | | | 0.25 | 1 |

### Device 1

A device having the following structure was formed:
ITO / HIL / HTL / EL / MF /Al / Ag
wherein ITO represents an indium-tin oxide anode; HIL is a hole-injection layer formed from a hole injecting material obtained from Plextronics, Inc. to a thickness of 50 nm; HTL is a 15 nm thick hole transport layer of a polymer comprising hole transport polymer 1 ; EL is electroluminescent layer formed to a thickness of 65 nmcontaining white Light-Emitting Polymer 1 illustrated below, MF is a metal fluoride, and the trilayer of MF (2 nm) / Al (200 nm) / Ag (100 nm) forms a cathode for the device.

HIL, HTL and EL were each formed by spin-coating followed by evaporation of the solvent. Following deposition of hole transporting polymer 1, the polymer layer was heated to crosslinking the benzocyclobutane groups of the polymer in order to render HTL insoluble prior to spin-coating of EL.

Light-Emitting Polymer 1 was formed by Suzuki polymerisation of a polymerisation mixture comprising the molar percentages of monomers illustrated below. The polymerisation was carried out as described in WO 00/53656, and the polymer was endcapped using the illustrated mono-brominated iridium complex to form a white light-emitting polymer.

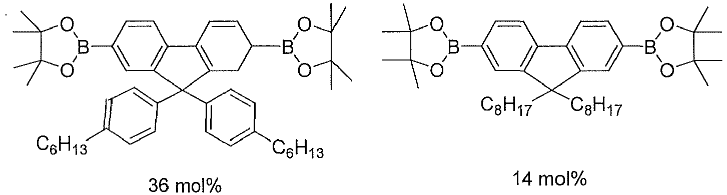

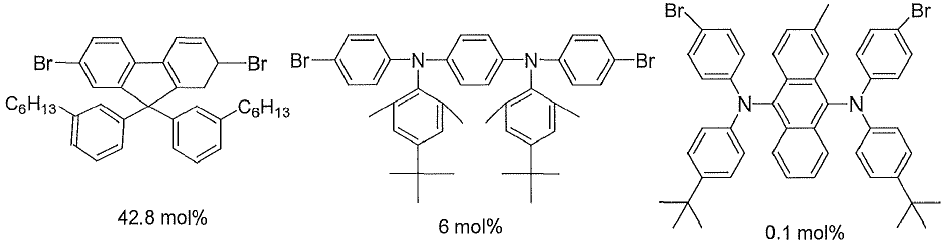

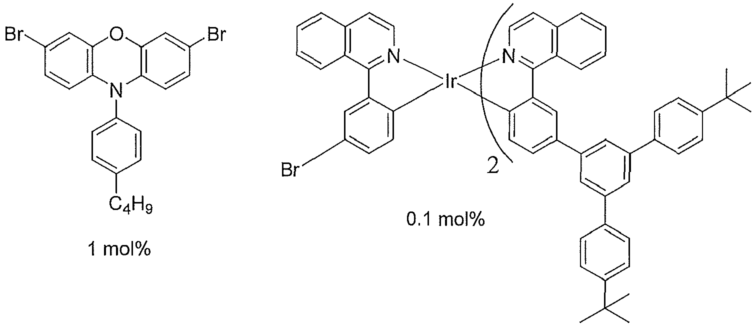

### Light Emitting Polymer 1

### Device 2

A device was prepared as per Example 1, except that hole transport layer 2 was used in place of hole transport layer 1.

Devices 1 and 2 are not embodiments according to the claims.

### Comparative Device 1

Comparative Device 1 was prepared as per Device 1, except that a non-emissive hole-transport layer was formed using comparative hole transport polymer 1 in place of hole transport layer 1.

The CIE (x,y) co-ordinates and lifetime (from an initial luminance of 5,000 cd/m²) were measured.

| Device | CIE (x) | CIE (y) | Lifetime (hours) |
|---|---|---|---|
| Comparative Device 1 | 0.315 | 0.320 | 9549 |
| Device 1 | 0.289 | 0.321 | 12354 |
| Device 2 | 0.304 | 0.311 | 11067 |

As can be seen from the above results, lifetime of the device was significantly increased by inclusion of fluorescent light-emitting species in the hole transport layer, without any significant change in colour of emission.

Without wishing to be bound by any theory, it is believed that inclusion of a fluorescent light-emitting species in the hole transporting layer provides a path for radiative decay of singlet excitons in the hole transporting layer.

### Device 3

A device was prepared as per Device 1, except that the hole transport layer was formed from hole transporting polymer 3 and the light-emitting layer was formed from blue Light-Emitting Polymer 2, which was formed by Suzuki polymerisation of the following monomers:

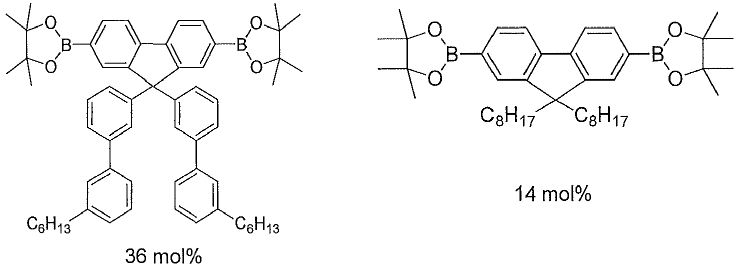

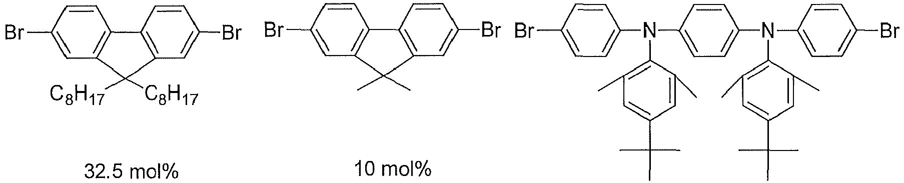

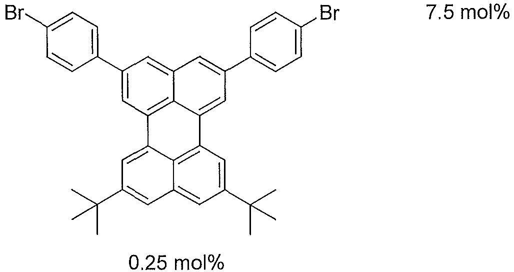

### Light Emitting Polymer 2

For the purpose of comparison, Comparative Device 2 was prepared as per Device 3 except that Comparative Hole Transport Polymer 1 was used in place of Hole Transporting Polymer 3.

| Device | CIEx, CIEy | Lifetime (hours) |
|---|---|---|
| Device 3 | 0.14, 0.19 | 390 |
| Comparative Device 2 | 0.14, 0.21 | 722 |

Device 3 is not an embodiment according to the claims.

### Device 4

A device was prepared as per Device 1, except that the light-emitting layer was formed from blue Light-Emitting Polymer 3, which was formed by Suzuki polymerisation of the following monomers:

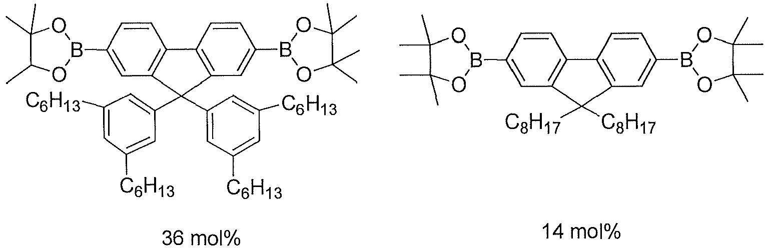

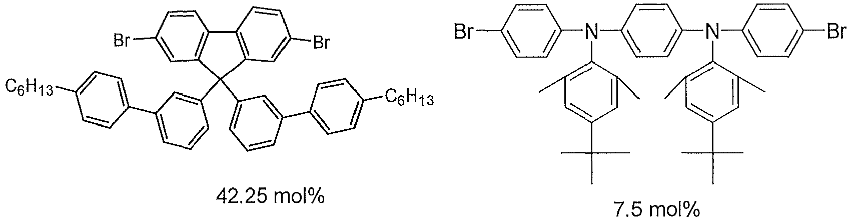

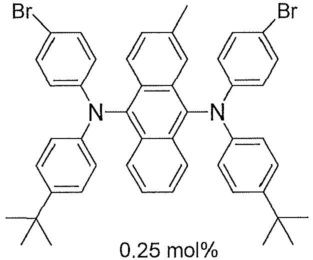

### Light-Emitting Polymer 3

For the purpose of comparison, Comparative Device 3 was prepared as per Device 4 except that Comparative Hole Transport Polymer 1 was used in place of Hole Transporting Polymer 1.

| Device | CIEx, CIEy | Lifetime (hours) |
|---|---|---|
| Comparative Device 3 | 0.14, 0.18 | 405 |
| Device 4 | 0.14, 0.21 | 542 |

Device 4 is not an embodiment according to the claims.

### Example 5

A device was prepared as per Device 1, except that the light-emitting layer was formed from Light-Emitting Polymer 5 and the hole transport layer was formed to a thickness of 15 nm from hole transport polymer 4:

| Monomer | Hole transport polymer 4 (mol %) | Comparative hole transport polymer 4 (mol %) |
|---|---|---|
| 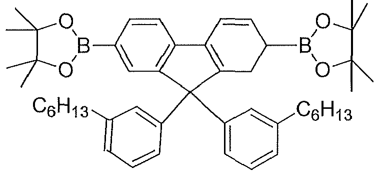 | 50 | 50 |
| 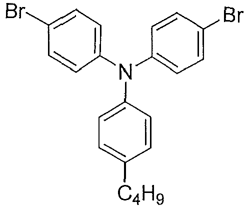 | 41.8 | 42.5 |
| 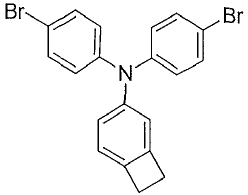 | 7.5 | 7.5 |
| 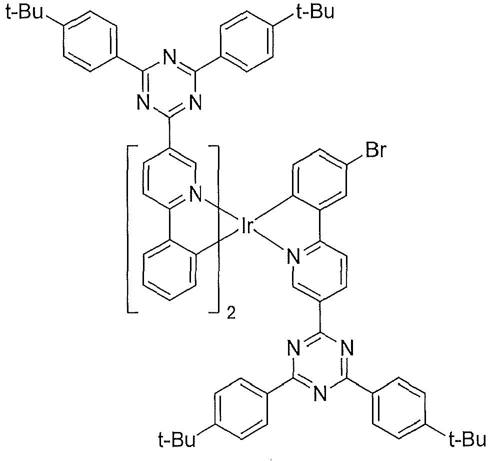 | 0.7 | |

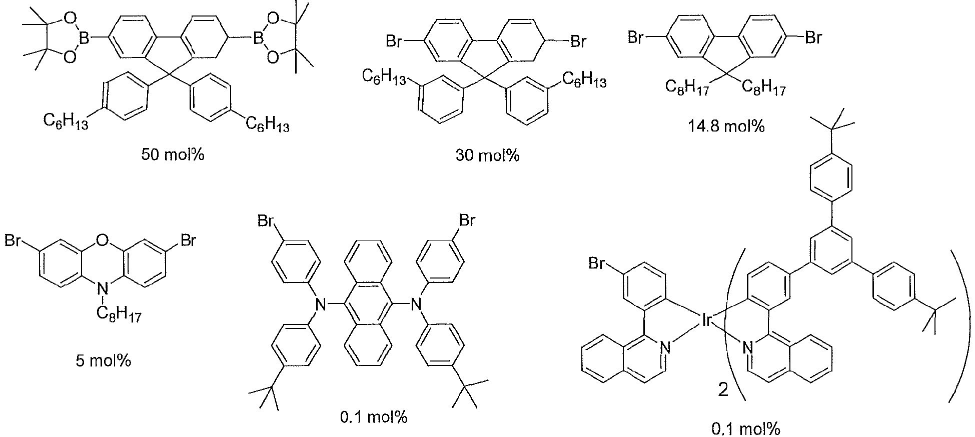

### Light-Emitting Polymer 5

For the purpose of comparison, Comparative Device 5 was formed as described with reference to Example 5 except that non-emissive comparative hole transport polymer 4 was used in place of emissive hole transport polymer 4.

### Example 6

A device was prepared as described in Example 5, except that the hole-transporting layer was formed to a thickness of 30 nm.

The CIE (x,y) co-ordinates and lifetime (from an initial luminance of 5,000 cd/m²) were measured.

| Example | CIE(x) | CIE(y) | Lifetime (hours) |
|---|---|---|---|
| Comparative Example 5 | 0.351 | 0.402 | 2809 |
| Example 5 | 0.437 | 0.388 | 3807 |
| Example 6 | 0.431 | 0.385 | 4793 |

As can be seen from the above results, lifetime of the device was significantly increased by inclusion of a phosphorescent light-emitting species in the hole transport layer, without any significant change in colour of emission.

Without wishing to be bound by any theory, it is believed that inclusion of a phosphorescent light-emitting species in the hole transporting layer provides a path for radiative decay of triplet excitons in the hole transporting layer.

### Examples 7 and 8

A device was prepared as described in Example 5, except that the hole transporting layer was formed from hole transport polymer 5 (in Example 7) and hole transport polymer 6 (in Example 8), and the light-emitting layer was formed from a composition comprising host polymer 1 and light-emitting dopant 1 in a 70:30 w/w blend:

| Monomer | Hole transport polymer 5 (mol %) | Hole transport polymer 6 (mol%) | Comparative hole transport polymer 5 (mol %) |
|---|---|---|---|
| 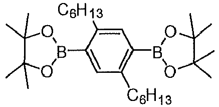 | 50 | 50 | 50 |
| 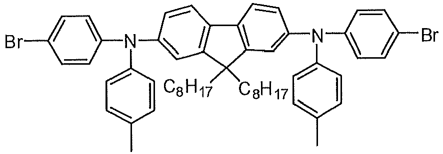 | 42.5 | 42.5 | 42.5 |
| 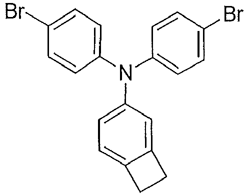 | 7.45 | 7.25 | 7.5 |
| 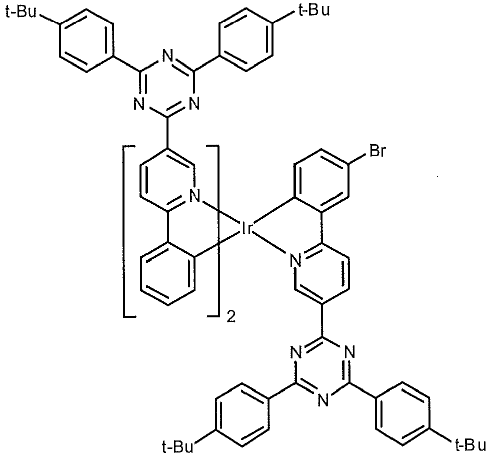 | 0.1 | 0.5 | |

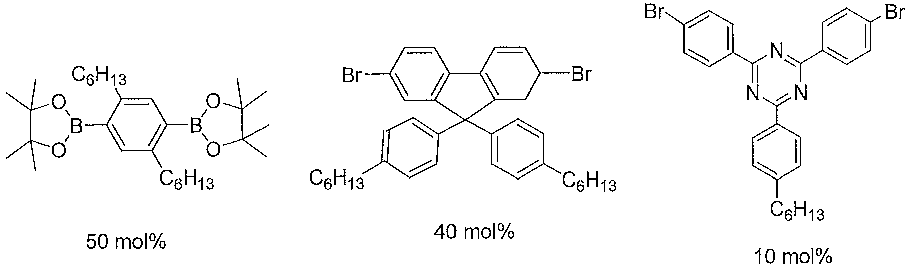

### Host Polymer 1

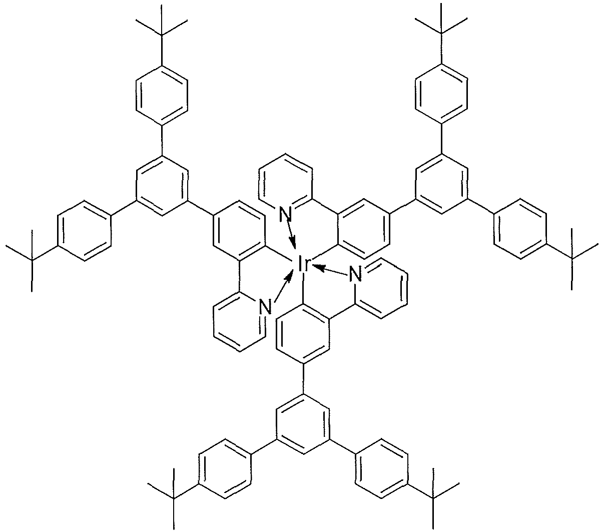

### Light-emitting dopant 1

For the purpose of comparison, Comparative Example 7 was prepared as described above for Example 7, except that comparative hole transport polymer 5 was used in place of hole transport polymer 5.

The CIE (x,y) co-ordinates and lifetime (from an initial luminance of 5,000 cd/m²) were measured.

| | CIE (x)_ | CIE (y) | Lifetime (hours) |
|---|---|---|---|
| Example 7 | 0.316 | 0.632 | 18986 |
| Example 8 | 0.341 | 0.612 | 21054 |
| Comparative Example 7 | 0.290 | 0.652 | 10730 |

As can be seen from the above results, lifetime of the device was significantly increased by inclusion of a phosphorescent light-emitting species in the hole transport layer, without any significant change in colour of emission.

Without wishing to be bound by any theory, it is believed that inclusion of a phosphorescent light-emitting species in the hole transporting layer provides a path for radiative decay of triplet excitons in the hole transporting layer.

Although the present invention has been described in terms of specific exemplary embodiments, it will be appreciated that various modifications, alterations and/or combinations of features disclosed herein will be apparent to those skilled in the art without departing from the scope of the invention as set forth in the following claims.

## Claims

1. An organic light-emitting device comprising an anode (2); a cathode (5) ; a charge transporting layer comprising a charge-transporting polymer doped with a phosphorescent light-emitting dopant between the anode (2) and the cathode (5) ; the device further comprising a light-emitting layer (4) between the anode (2) and the cathode (5), wherein:
the x-coordinate value and / or the y-coordinate value of CIE(x,y) coordinates of light emitted from the device is no more than 0.05 from the respective x- or y-coordinate value of a control device in which the charge transporting layer is not doped with a light-emitting dopant; wherein the charge transporting layer is adjacent to the light-emitting layer (4); and wherein the light-emitting dopant is a repeat unit in the main chain of the charge-transporting polymer or a side-group or end-group of the charge-transporting polymer; **characterized in that** the phosphorescent dopant is present in the charge-transporting layer in an amount no more than 0.75 mol%.

2. An organic light-emitting device according to claim 1 wherein the charge transporting layer is a hole transporting layer located between the anode and the light-emitting layer.

3. An organic light-emitting device according to claim 1 or 2 wherein the light-emitting dopant is an end-group of the charge-transporting polymer.

4. An organic light-emitting device according to any preceding claim wherein the light-emitting layer comprises a host material and a light-emitting dopant that is mixed with or chemically bound to the host material.

5. An organic light-emitting device according to claim 4 wherein the the host material is a polymer.

6. An organic light-emitting device according to claim 5 wherein the host polymer comprises arylamine repeat units.

7. An organic light-emitting device according to any one of the preceding claims wherein the charge-transporting polymer comprises arylamine repeat units.

8. An organic light-emitting device according to claim 6 or 7 wherein the arylamine repeat units are units of formula (V): 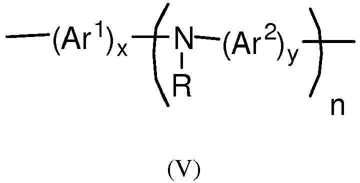 wherein Ar¹ and Ar² are optionally substituted aryl or heteroaryl groups, n is greater than or equal to 1, preferably 1 or 2, x and y are each independently at least 1 and R is H or a substituent.

9. An organic light-emitting device according to claim 8 wherein R is Ar³, wherein Ar³ is an optionally substituted aromatic or heteroaromatic group, and wherein any two of Ar¹, Ar² and Ar³ may be linked by a direct bond or a divalent linking group.

10. An organic light-emitting device according to any preceding claim wherein the charge-transporting polymer comprises aryl or heteroaryl repeat units.

11. An organic light-emitting device according to claim 10 wherein the charge-transporting polymer comprises repeat units of formula (IV): 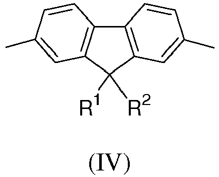 wherein R¹ and R² are independently H or a substituent, and R¹ and R² may be linked to form a ring.

12. An organic light-emitting device according to claim 10 or 11 wherein the charge-transporting polymer comprises repeat units of formula (VII): 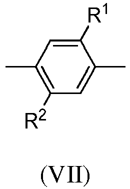 wherein R¹ and R² are independently H or a substituent.

13. An organic light-emitting device according to any one of claims 1 and 3-12 wherein the charge transporting layer is an electron-transporting layer located between the cathode and the light-emitting layer.

14. A method of forming an organic light-emitting device according to any preceding claim comprising the steps of depositing the charge transporting layer and the light-emitting layer over one of the anode and cathode and depositing the other of the anode and cathode over the charge transporting layer and the light-emitting layer, wherein at least one of the charge transporting layer and the light emitting layer are deposited from a solution in a solvent.

15. A method according to claim 14 wherein the first of the charge transporting layer and the light emitting layer to be deposited is crosslinked following deposition, and wherein the other of the charge transporting layer and the light emitting layer is deposited onto the first-deposited layer from a solution in a solvent.

## Patentansprüche

1. Organische lichtemittierende Vorrichtung, die Folgendes beinhaltet:
eine Anode (2);
eine Kathode (5);
eine ladungstransportierende Schicht, die ein ladungstransportierendes Polymer beinhaltet, die mit einem phosphoreszierenden lichtemittierenden Dotierstoff zwischen der Anode (2) und der Kathode (5) dotiert ist;
wobei die Vorrichtung ferner eine lichtemittierende Schicht (4) zwischen der Anode (2) und der Kathode (5) aufweist, wobei:
der x-Koordinatenwert und/oder der y-Koordinatenwert von CIE(x,y)-Koordinaten von Licht, das von der Vorrichtung emittiert wird, nicht mehr als 0,05 von dem jeweiligen x- oder y-Koordinatenwert einer Steuerungsvorrichtung ist, in der die ladungstransportierende Schicht nicht mit einem lichtemittierenden Dotierstoff dotiert ist; wobei die ladungstransportierende Schicht an die lichtemittierende Schicht (4) angrenzt;
und wobei der lichtemittierende Dotierstoff eine Wiederholeinheit in der Hauptkette des ladungstransportierenden Polymers oder eine Nebengruppe oder Endgruppe des ladungstransportierenden Polymers ist; **dadurch gekennzeichnet, dass** der phosphoreszierende Dotierstoff in der ladungstransportierenden Schicht in einer Menge von nicht mehr als 0,75 Mol-% vorliegt.

2. Organische lichtemittierende Vorrichtung gemäß Anspruch 1, wobei die ladungstransportierende Schicht eine lochtransportierende Schicht ist, die sich zwischen der Anode und der lichtemittierenden Schicht befindet.

3. Organische lichtemittierende Vorrichtung gemäß Anspruch 1 oder 2, wobei der lichtemittierende Dotierstoff eine Endgruppe des ladungstransportierenden Polymers ist.

4. Organische lichtemittierende Vorrichtung gemäß einem vorhergehenden Anspruch, wobei die lichtemittierende Schicht ein Hostmaterial und einen lichtemittierenden Dotierstoff, der mit dem Hostmaterial vermischt oder chemisch gebunden ist, beinhaltet.

5. Organische lichtemittierende Vorrichtung gemäß Anspruch 4, wobei das Hostmaterial ein Polymer ist.

6. Organische lichtemittierende Vorrichtung gemäß Anspruch 5, wobei das Hostpolymer Arylamin-Wiederholeinheiten beinhaltet.

7. Organische lichtemittierende Vorrichtung gemäß einem der vorhergehenden Ansprüche, wobei das ladungstransportierende Polymer Arylamin-Wiederholeinheiten beinhaltet.

8. Organische lichtemittierende Vorrichtung gemäß Anspruch 6 oder 7, wobei die Arylamin-Wiederholeinheiten Einheiten der Formel (V) sind: 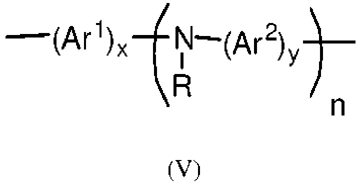 wobei Ar¹ und Ar² optional substituierte Aryl- oder Heteroarylgruppen sind, n größer als oder gleich 1 ist, bevorzugt 1 oder 2, x und y jeweils unabhängig mindestens 1 sind und R H oder ein Substituent ist.

9. Organische lichtemittierende Vorrichtung gemäß Anspruch 8, wobei R Ar³ ist, wobei Ar³ eine optional substituierte aromatische oder heteroaromatische Gruppe ist und wobei beliebige zwei Ar¹, Ar² und Ar³ durch eine direkte Bindung oder zweiwertige Vernetzungsgruppe vernetzt sein können.

10. Organische lichtemittierende Vorrichtung gemäß einem vorhergehenden Anspruch, wobei das ladungstransportierende Polymer Aryl- oder Heteroaryl-Wiederholeinheiten beinhaltet.

11. Organische lichtemittierende Vorrichtung gemäß Anspruch 10, wobei das ladungstransportierende Polymer Wiederholeinheiten der Formel (IV) beinhaltet: 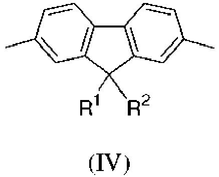 wobei R¹ und R² unabhängig H oder ein Substituent sind und R¹ und R² vernetzt sein können, um einen Ring zu bilden.

12. Organische lichtemittierende Vorrichtung gemäß Anspruch 10 oder 11, wobei das ladungstransportierende Polymer Wiederholeinheiten der Formel (VII) beinhaltet: 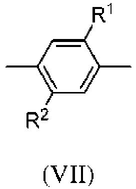 wobei R¹ und R² unabhängig H oder ein Substituent sind,

13. Organische lichtemittierende Vorrichtung gemäß einem der Ansprüche 1 und 3-12, wobei die ladungstransportierende Schicht eine elektronentransportierende Schicht ist, die sich zwischen der Kathode und der lichtemittierenden Schicht befindet.

14. Verfahren zum Bilden einer organischen lichtemittierenden Vorrichtung gemäß einem vorhergehenden Anspruch, das die Schritte des Aufbringens der ladungstransportierenden Schicht und der lichtemittierenden Schicht über eine von der Anode und der Kathode und des Aufbringens der anderen von der Anode und der Kathode über die ladungstransportierende und die lichtemittierende Schicht beinhaltet, wobei mindestens eine von der ladungstransportierenden Schicht und der lichtemittierenden Schicht aus einer Lösung in einem Lösungsmittel aufgebracht wird.

15. Verfahren gemäß Anspruch 14, wobei die erste der aufzubringenden ladungstransportierenden Schicht und der lichtemittierenden Schicht nach dem Aufbringen quervernetzt wird und wobei die andere der aufzubringenden ladungstransportierenden Schicht und der lichtemittierenden Schicht auf die erste aufgebrachte Schicht aus einer Lösung in einem Lösungsmittel aufgebracht wird.

## Revendications

1. Dispositif émetteur de lumière organique comprenant une anode (2) ;
une cathode (5) ;
une couche de transport de charge comprenant un polymère de transport de charge dopé avec un dopant phosphorescent émetteur de lumière entre l'anode (2) et la cathode (5) ;
le dispositif comprenant en outre une couche émettrice de lumière (4) entre l'anode (2) et la cathode (5), dans lequel :
la valeur de coordonnée x et/ou la valeur de coordonnée y des coordonnées CIE(x,y) de la lumière émise à partir du dispositif n'est pas supérieure de plus de 0,05 à la valeur de coordonnée x ou y respective d'un dispositif témoin dans lequel la couche de transport de charge n'est pas dopée avec un dopant émetteur de lumière ; dans lequel la couche de transport de charge est adjacente à la couche émettrice de lumière (4) ;
et dans lequel le dopant émetteur de lumière est un motif de répétition dans la chaîne principale du polymère de transport de charge ou d'un groupe latéral ou d'un groupe d'extrémité du polymère de transport de charge ; **caractérisé en ce que** le dopant phosphorescent est présent dans la couche de transport de charge dans une quantité de pas plus de 0,75 mol %.

2. Dispositif émetteur de lumière organique selon la revendication 1 dans lequel la couche de transport de charge est une couche de transport de trous située entre l'anode et la couche émettrice de lumière.

3. Dispositif émetteur de lumière organique selon la revendication 1 ou 2 dans lequel le dopant émetteur de lumière est un groupe d'extrémité du polymère de transport de charge.

4. Dispositif émetteur de lumière organique selon l'une quelconque des revendications précédentes dans lequel la couche émettrice de lumière comprend un matériau hôte et un dopant émetteur de lumière qui est mélangé avec le matériau hôte ou lié chimiquement au matériau hôte.

5. Dispositif émetteur de lumière organique selon la revendication 4 dans lequel le matériau hôte est un polymère.

6. Dispositif émetteur de lumière organique selon la revendication 5 dans lequel le matériau hôte comprend des motifs de répétition arylamine.

7. Dispositif émetteur de lumière organique selon l'une quelconque des revendications précédentes dans lequel le polymère de transport de charge comprend des motifs de répétition arylamine.

8. Dispositif émetteur de lumière organique selon la revendication 6 ou 7 dans lequel les motifs de répétition arylamine sont des motifs de formule (V) : 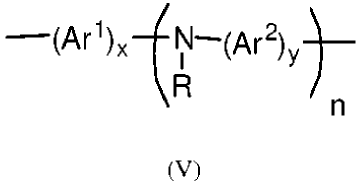 dans lequel Ar¹ et Ar² sont facultativement des groupes aryle ou hétéroaryle facultativement substitués, n est supérieur ou égal à 1, préférablement 1 ou 2, x et y sont chacun indépendamment au moins 1 et R est H ou un substituant.

9. Dispositif émetteur de lumière organique selon la revendication 8 dans lequel R est Ar³, dans lequel Ar³ est un groupe aromatique ou hétéroaromatique facultativement substitué, et dans lequel deux quelconques de Ar¹, Ar² et Ar³ peuvent être liés par une liaison directe ou un groupe de liaison divalent.

10. Dispositif émetteur de lumière organique selon l'une quelconque des revendications précédentes dans lequel le polymère de transport de charge comprend des motifs de répétition aryle ou hétéroaryle.

11. Dispositif émetteur de lumière organique selon la revendication 10 dans lequel le polymère de transport de charge comprend des motifs de répétition de formule (IV) : 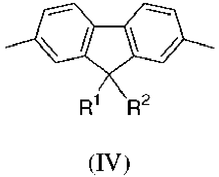 dans lequel R¹ et R² sont indépendamment H ou un substituant, et R¹ et R² peuvent être liés pour former un noyau.

12. Dispositif émetteur de lumière organique selon la revendication 10 ou 11 dans lequel le polymère de transport de charge comprend des motifs de répétition de formule (VII) : 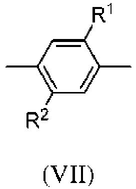 dans lequel R¹ et R² sont indépendamment H ou un substituant.

13. Dispositif émetteur de lumière organique selon l'une quelconque des revendications 1 et 3 à 12 dans lequel la couche de transport de charge est une couche de transport d'électrons située entre la cathode et la couche émettrice de lumière.

14. Procédé de formation d'un dispositif émetteur de lumière organique selon l'une quelconque des revendications précédentes comprenant les étapes de dépôt de la couche de transport de charge et de la couche émettrice de lumière sur l'une de l'anode et de la cathode et le dépôt de l'autre de l'anode et de la cathode sur la couche de transport de charge et la couche émettrice de lumière, dans lequel au moins l'une de la couche de transport de charge et de la couche émettrice de lumière est déposée à partir d'une solution dans un solvant.

15. Procédé selon la revendication 14 dans lequel la première de la couche de transport de charge et de la couche émettrice de lumière à être déposée est réticulée suite au dépôt, et dans lequel l'autre de la couche de transport de charge et de la couche émettrice de lumière est déposée sur la couche déposée en premier à partir d'une solution dans un solvant.
